(19) **Europäisches Patentamt / European Patent Office / Office européen des brevets**

(11) **EP 4 586 011 A1**

(12) **EUROPEAN PATENT APPLICATION**

(43) Date of publication:
**16.07.2025 Bulletin 2025/29**

(21) Application number: **24176403.4**

(22) Date of filing: **16.05.2024**

(51) International Patent Classification (IPC):
*G03F 1/26* *(2012.01)*

(52) Cooperative Patent Classification (CPC):
**G03F 1/26**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **15.01.2024 KR 20240006011**

(71) Applicant: S&S Tech Co., Ltd.
**Daegu 42714 (KR)**

(72) Inventors:
• **YUN, Jong-Won**
  **42714 Daegu (KR)**
• **YANG, Chul-Kyu**
  **42714 Daegu (KR)**
• **PARK, Min-Kyu**
  **42714 Daegu (KR)**
• **WOO, Mi-Kyung**
  **42714 Daegu (KR)**
• **KIM, Yong-Dae**
  **42714 Daegu (KR)**

(74) Representative: **ABG Intellectual Property Law, S.L.**
**Avenida de Burgos, 16D**
**Edificio Euromor**
**28036 Madrid (ES)**

(54) **REVERSE PHOTOMASK THAT PHASE SHIFT FILM PATTERN IS USED FOR REFLECTIVE PATTERN, AND BLANKMASK FOR MANUFACTURING THE SAME**

(57)    The reverse photomask functions such that the hole pattern of the photomask acts as a shading pattern, and the dot pattern functions as a reflection pattern. The reverse blankmask for manufacturing a reverse photomask has a reflective film formed on the substrate, and a phase shift film formed on the reflective film. The phase shift film exceeds a relative reflectivity of 15% for EUV exposure light at a wavelength of 13.5nm, has a phase shift amount of 110-150° or 220-250°, and has a thickness of less than 45nm. When using the reverse photomask to expose a wafer applied with negative photoresist, the hole and dot patterns of the photomask respectively form hole and dot patterns on the wafer.

**FIG. 29**

EP 4 586 011 A1

## Description

## BACKGROUND

**Field**

The present invention relates to a blankmask and a photomask, and more particularly, to a reverse photomask that phase shift film pattern is used for a reflective pattern, and a blankmask for manufacturing the same

**Description of the Related Art**

Blankmasks used in EUV lithography typically consist of two thin films on the substrate: a reflective film that reflects EUV light, and an absorption film that absorbs EUV light. Recently, phase shift blankmasks have been developed that can achieve higher resolution compared to binary blankmasks equipped with the aforementioned absorption film. Phase shift blankmasks have a higher Normalized Image Log Slope (NILS) compared to binary blankmasks, which allows for the reduction of stochastic defects caused by the Shot Noise Effect during Wafer Printing. Additionally, phase shift blankmasks can implement a lower Dose to Space (DtS), increasing semiconductor productivity.

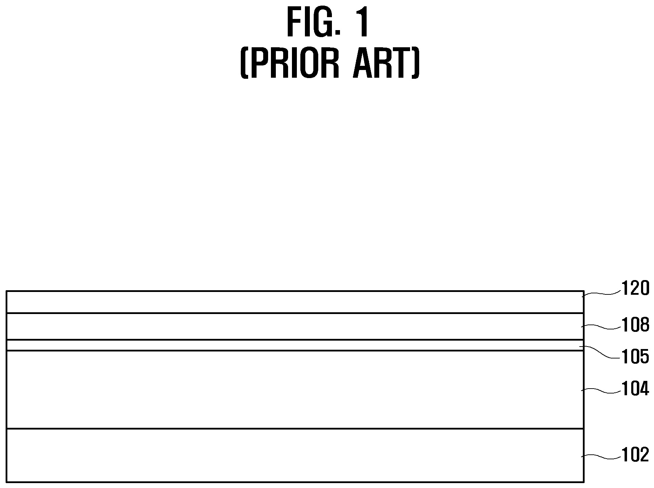

Figure 1 illustrates the basic structure of a phase shift blankmask for extreme ultraviolet lithography. The phase shift blankmask for extreme ultraviolet lithography includes a substrate 102, a reflective film 104 formed on the substrate 102, a capping film 105 formed on the reflective film 104, a phase shift film 108 formed on the capping film 105, and a resist film 120 formed on the phase shift film 108.

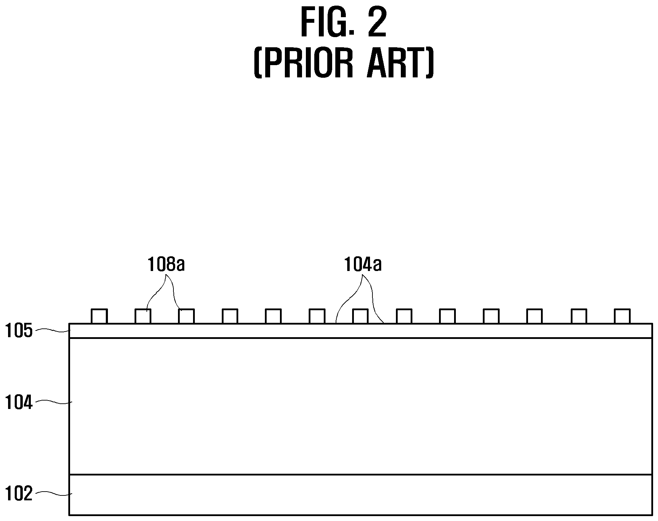

Figure 2 shows a photomask manufactured using the blankmask from Figure 1. After patterning the resist film 120 of the blankmask from Figure 1, the patterned resist film 120 is used as an etching mask to pattern the phase shift film 108. Then, by removing the pattern of the resist film 120, the manufacturing of the photomask with the phase shift pattern 108a and the reflective film pattern 104a is completed. When EUV exposure light is incident on this photomask, the incident light that hits the reflective film pattern 104a is reflected onto the wafer, and the incident light that hits the phase shift film pattern 108a is substantially extinguished by destructive interference before being projected onto the wafer. The contrast difference of the reflected light projected onto the wafer patterns the photoresist on the wafer.

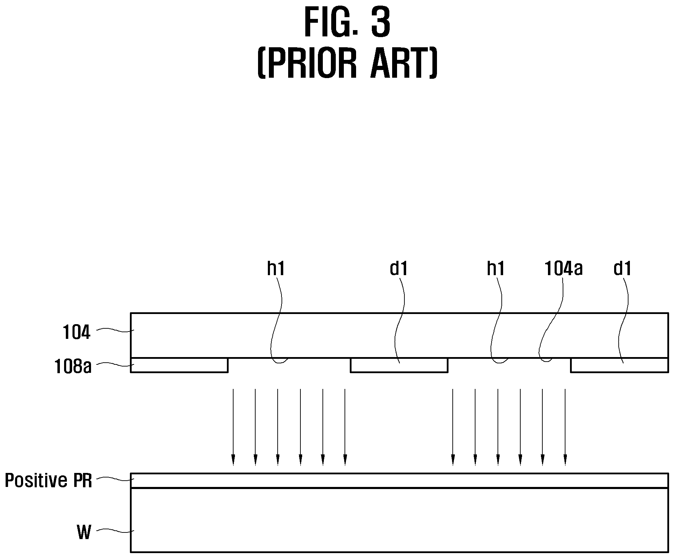

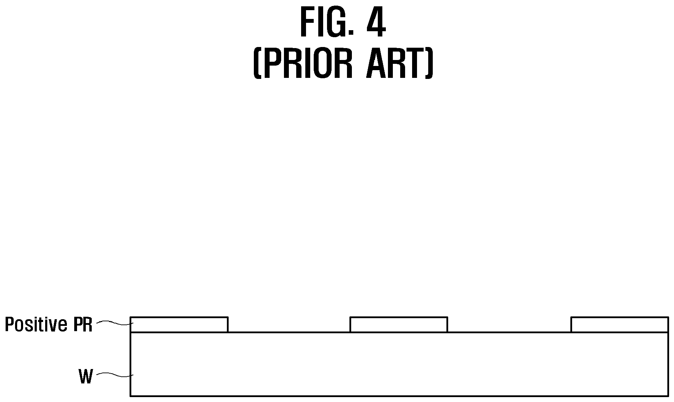

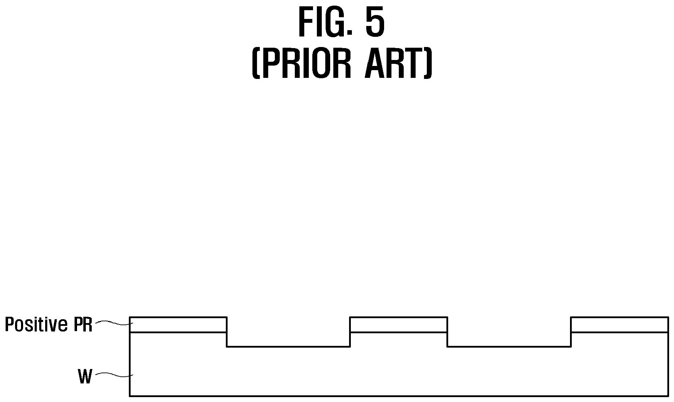

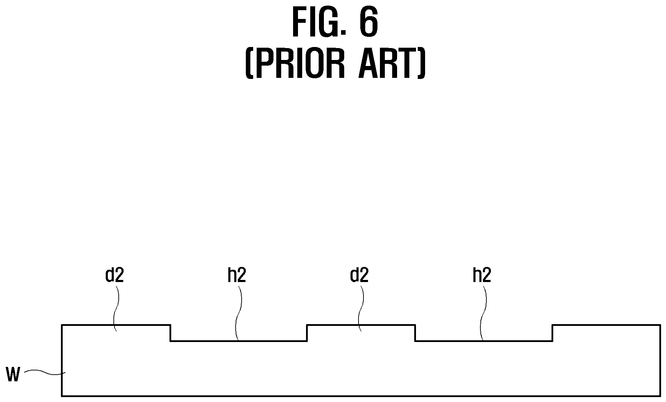

Figures 3 to 6 sequentially illustrate the process of patterning a wafer using the photomask of Figure 2, specifically showing the process of patterning a wafer (W) employing positive photoresist PR. For convenience in illustration and description, only parts of the reflective film 104 and phase shift pattern 108a of the photomask from Figure 2 are shown in Figures 3 to 6, and only the reflected light is illustrated, omitting the incident light striking the photomask. In Figure 3, the protruding dot part for patterning on the photomask, i.e., the phase shift pattern 108a, is marked as d1, and the recessed part, i.e., the hole where the phase shift film 108 is removed to expose the reflective film 104, is marked as h1. In Figure 6, the protruding dot part in the pattern after patterning of the wafer (W) is marked as d2, and the recessed hole part is marked as h2.

As shown in Figure 3, the EUV exposure light is reflected from the photomask onto the wafer (W), where the EUV exposure light is reflected from the hole (h1) part where the reflective film pattern 104a is formed and shadowed in the dot (d1) part where the phase shift pattern 108a is formed. As the patterned reflected light is projected onto the wafer (W), the areas of the positive resist exposed to the reflected light are removed, patterning the positive resist as shown in Figure 4. Using the patterned positive resist as an etching mask, the wafer (W) is etched as shown in Figure 5, and after etching is completed and then the positive photoresist is removed, a patterned wafer (W) is obtained as shown in Figure 6.

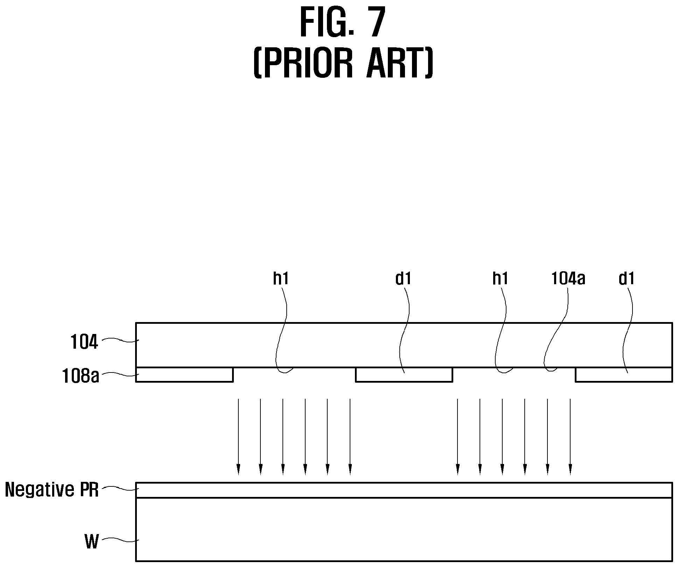

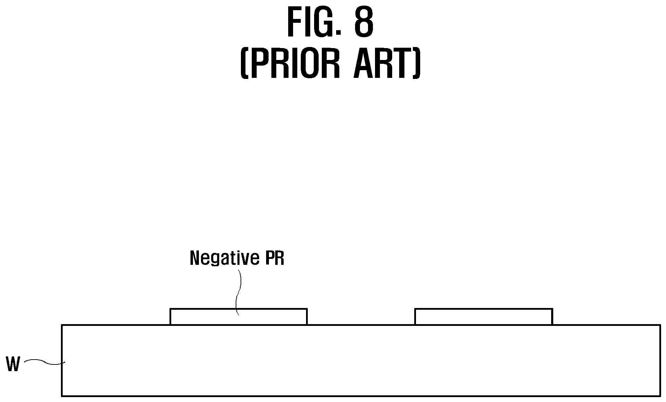

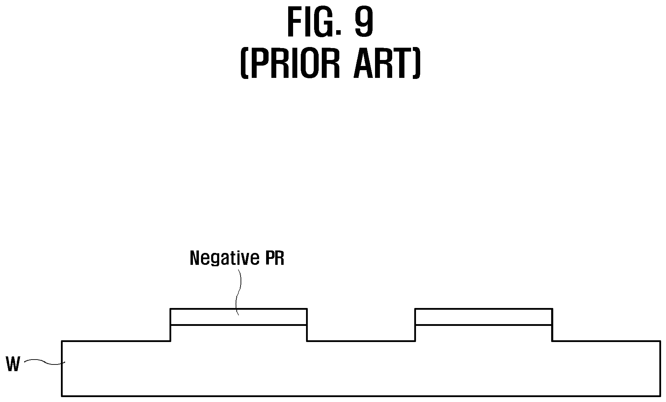

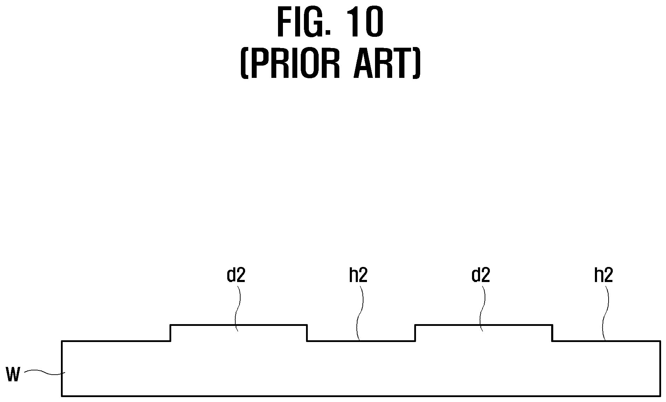

Figures 7 to 10 sequentially illustrate the process of patterning a wafer using the photomask of Figure 2, specifically showing the process of patterning a wafer (W) employing negative photoresist PR. As shown in Figure 7, in the case of employing negative photoresist, the areas of the negative photoresist exposed to the reflected light remain while the rest are removed, as shown in Figure 8. Using the patterned negative photoresist as an etching mask, the wafer (W) is etched as shown in Figure 9, and after etching is completed and then the negative photoresist is removed, a patterned wafer (W) is obtained as shown in Figure 10.

When performing the exposure process on a wafer using a conventional photomask, patterning the wafer (W) employing positive resist results in the formation of holes (h2) on the wafer (W) corresponding to the holes (h1) of the photomask and the formation of dots (d2) on the wafer (W) corresponding to the dots (d1) of the photomask, as in the case of Figures 3 to 6. Conversely, when patterning a wafer (W) employing negative resist, as in the case of Figures 7 to 10, the holes (h1) of the photomask result in the formation of dots (d2) on the wafer (W), and the dots (d1) of the photomask result in the formation of holes (h2) on the wafer (W).

Generally, negative photoresist is thinner and can form fine patterns with a lower dose compared to positive photoresist, which results in higher productivity and better performance. Therefore, the active application of negative photoresist on wafer (W) is being considered. When negative photoresist is applied to the wafer (W), as described, holes (h1) in the photoresist form dots (d2) on the wafer (W).

However, the final exposure process in the fabrication of semiconductor devices always involves forming holes (h2) on the wafer (W). This means that after a process that forms dots (d2) on the wafer (W), one or more additional processes are always required to form holes (h2). Therefore, positive photoresist should be used in the final exposure process, and thus, the reduced dose achieved through the application of negative photoresist in previous exposure processes does not directly lead to increased productivity in the overall process.

If one wishes to apply negative photoresist in the final exposure process as well, the dot (d1) patterns of the photomask must be used to form holes (h2) on the wafer (W). However, due to technical limitations in processing the photomask pattern, i.e., the phase shift pattern 108a, it is impossible to reduce the pattern size to the required level of hole (h1) size. Additionally, defects in the form of footing at the bottom of the pattern 108a caused by the exposure light reflected from the reflective film 104 can result in reduced uniformity of the hole (h2) sizes formed on the wafer (W).

Due to these issues, despite the advantages of negative photoresist, its application in actual wafer (W) patterning processes has been limited.

In the two examples described, the hole (h1) in the photomask was used as a reflective pattern reflecting the exposure light, and the dot (d1) was used as a shading pattern that blocks the exposure light. Conversely, research is being conducted on a configuration where the exposure light is blocked in the area of the wafer (W) corresponding to the hole (h1) of the photomask, and the exposure light is projected in the area of the wafer (W) corresponding to the dot (d1) of the photomask. As a result, from the wafer's (W) perspective, it is as if the hole (h1) functions like a shading pattern and the dot (d1) functions like a reflective pattern. This type of photomask will hereinafter be referred to as a "reverse photomask." Using a reverse photomask in the exposure process, when negative photoresist is applied to the wafer (W), the dot pattern of the photomask forms a dot pattern on the wafer (W), and the hole pattern of the photomask forms a hole pattern on the wafer (W). Thus, the benefits of negative photoresist can be achieved while resolving the issues described above.

To manufacture such a reverse photomask, the characteristics of the blankmask material must be entirely different from those of conventional blankmasks. However, to date, there has been no information on the composition of blank masks for the manufacture of reverse photomasks.

## SUMMARY

The present invention has been devised to solve the above-mentioned problems, with the objective of providing a reverse photomask where the exposure light is blocked in the areas of the wafer corresponding to the reflective film patterns of the photomask, and the exposure light is projected in the areas of the wafer corresponding to the phase shift film patterns of the photomask. Consequently, from the perspective of the wafer, it is as if the hole patterns of the photomask function as shading patterns, and the dot patterns function as reflective patterns.

Another objective of this invention is to provide a blankmask that can be used in the manufacture of such reverse photomasks.

The reverse blankmask for extreme ultraviolet lithography according to the first aspect of the present invention comprises: a substrate, a reflective film formed on the substrate, and a phase shift film formed on the reflective film, wherein a relative reflectivity of the phase shift film is greater than 15% for EUV exposure light at a wavelength of 13.5nm, and a phase shift amount of reflected light from the phase shift film during EUV exposure light incidence is within a range of 110-150° or 220-250°.

The reverse blankmask for extreme ultraviolet lithography according to the second aspect of the present invention comprises: a substrate, a reflective film formed on the substrate, and a phase shift film formed on the reflective film, wherein a relative reflectivity of the phase shift film is greater than 15% for EUV exposure light at a wavelength of 13.5nm, and a thickness of the phase shift film is less than 45nm.

Various constitutions can be added to the reverse blankmask for extreme ultraviolet lithography according to the first and the second aspects of the present invention as follows.

It is preferable that the phase shift film has a relative reflectivity of less than 35%.

It is preferable that the phase shift film has a thickness of less than 35nm, and more preferably, less than 30nm.

The reverse blankmask can be constituted to satisfy any one of the following formulas 1) to 5):

1) $32.5\% < R < 35\%$, $-0.1275n + 0.1305 < k < -6.6692n^2 + 12.1540n - 5.5071$
2) $27.5\% < R < 32.5\%$, $-0.1500n + 0.1530 < k < -6.0311n^2 + 10.9240n - 4.9149$
3) $22.5\% < R < 27.5\%$, $-0.1875n + 0.1900 < k < -4.2609n^2 + 7.6028n - 3.3581$
4) $17.5\% < R < 22.5\%$, $-0.2362n + 0.2376 < k < -2.5346n^2 + 4.3613n - 1.8379$
5) $15\% < R < 17.5\%$, $-0.3112n + 0.3108 < k < -7.9010n^2 + 14.1850n - 6.3175$

(For EUV exposure light, R represents the relative reflectivity, k represents the extinction coefficient, and n represents the refractive index.)

As a further restricted range compared to the formulas 1) to 5), the reverse blankmask can be constituted to satisfy any one of the following formulas 6) to 10):

6) 32.5% < R < 35%, -0.1275n + 0.1305 < k < -1.6193n^2 + 2.8439n - 1.2255
7) 27.5% < R < 32.5%, -0.1500n + 0.1530 < k < -1.3636n^2 + 2.3341n - 0.9713
8) 22.5% < R < 27.5%, -0.1875n + 0.1900 < k < -1.7045n^2 + 2.9001n - 1.2006
9) 17.5% < R < 22.5%, -0.2362n + 0.2376 < k < -0.9554n^2 + 1.4681n - 0.5146
10) 15% < R < 17.5%, -0.3112n + 0.3108 < k < -0.7670n^2 + 0.9870n - 0.2242

Besides the ranges defined by the formulas 1) to 10), the reverse blankmask can be constituted to satisfy any one of the following formulas 11) to 14):

11) 32.5% < R < 35%, n=0.92±0.01, -0.1275n + 0.1305 < k < 0.03
12) 27.5% < R < 32.5%, n=0.89±0.01 or n=0.92±0.01, -0.1500n + 0.1530 < k < 0.03
13) 22.5% < R < 27.5%, n=0.92±0.01, -0.1875n + 0.1900 < k < 0.03
14) 15% < R < 17.5%: at n=0.90±0.01, -0.3112n + 0.3108 < k < 0.05

According to another aspect of the present invention, a reverse photomask for extreme ultraviolet lithography manufactured using the blankmask according to the above is provided.

According to still another aspect of the present invention, a method of exposing a wafer, comprising the steps of manufacturing the reverse photomask of claim 13, and exposing the wafer using the reverse photomask is provided.

Preferably, the wafer employs negative photoresist during the exposing step.

According to this invention, a reverse photomask is provided in which the phase shift film pattern and the reflective film pattern respectively act as reflective and shading patterns for EUV incident light, along with a blankmask used in the manufacturing of such a photomask. When this invention's photomask is used for exposing a wafer applied with negative photoresist, the photoresist's hole pattern can be used to form a hole pattern on the wafer. Thus, it is possible to obtain the benefits of negative photoresist while resolving the issues associated with using conventional photomasks.

## BRIEF DESCRIPTION OF THE DRAWINGS

Figure 1 illustrates the basic structure of a conventional phase shift blankmask for extreme ultraviolet lithography.
Figure 2 shows a photomask manufactured using the blankmask of Figure 1.
Figures 3 to 6 sequentially illustrate the process of patterning a wafer applied with positive photoresist using the photomask of Figure 2.
Figures 7 to 10 sequentially illustrate the process of patterning a wafer applied with negative photoresist using the photomask of Figure 2.

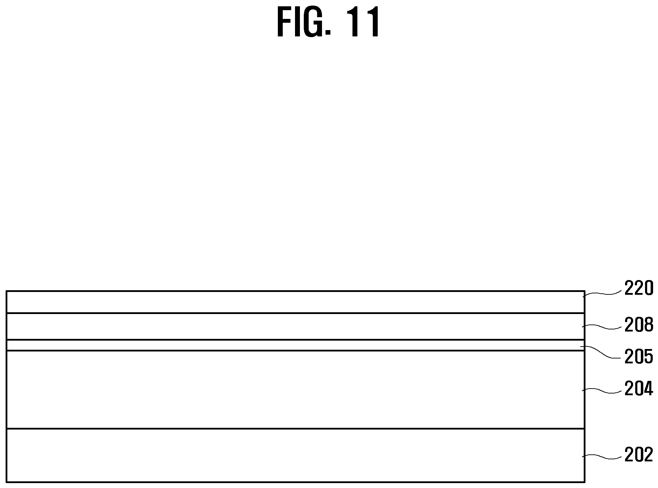

Figure 11 illustrates a blankmask for the manufacture of a reverse photomask according to this invention.

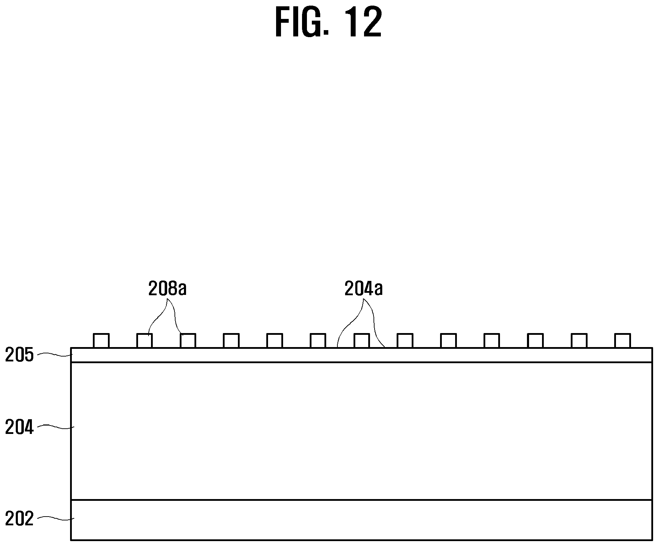

Figure 12 shows a photomask manufactured using the blankmask of Figure 11.

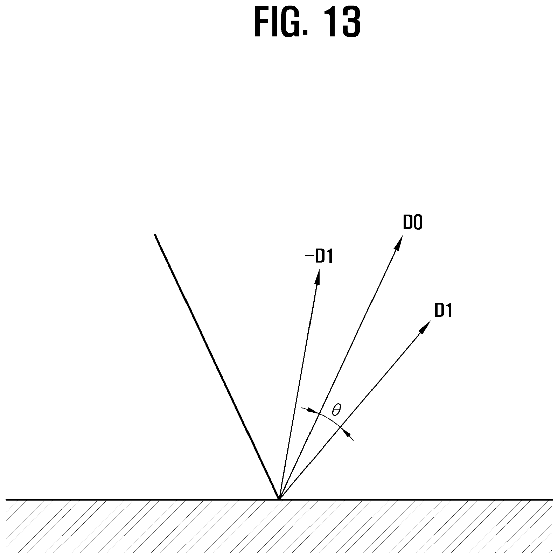

Figure 13 explains the diffraction of reflected light.

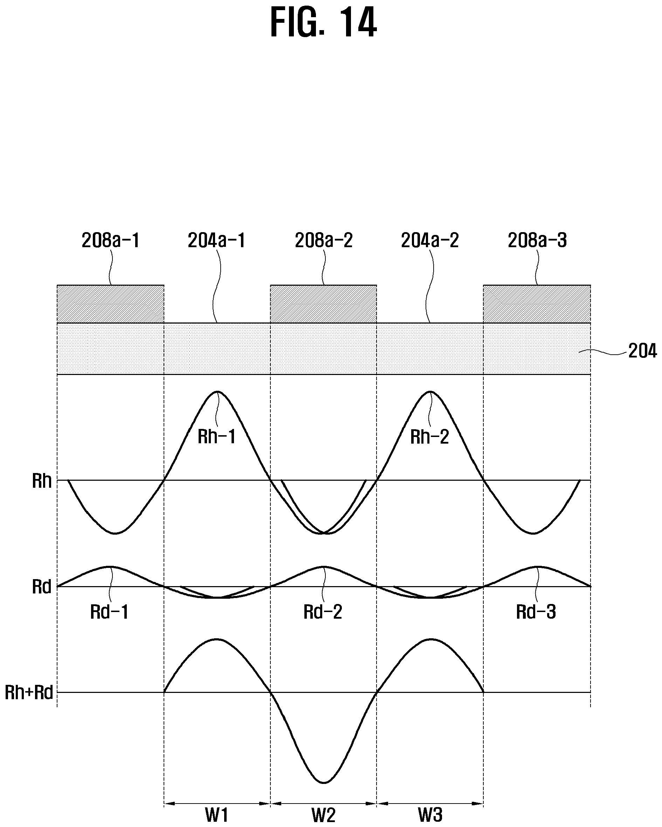

Figure 14 shows the intensity variation of light in each area of the wafer due to the reflected light and its diffracted light from the photomask of Figure 12.

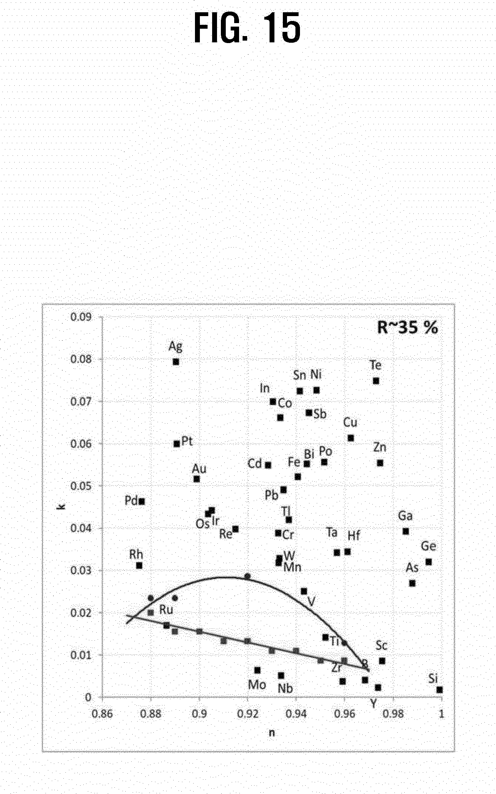

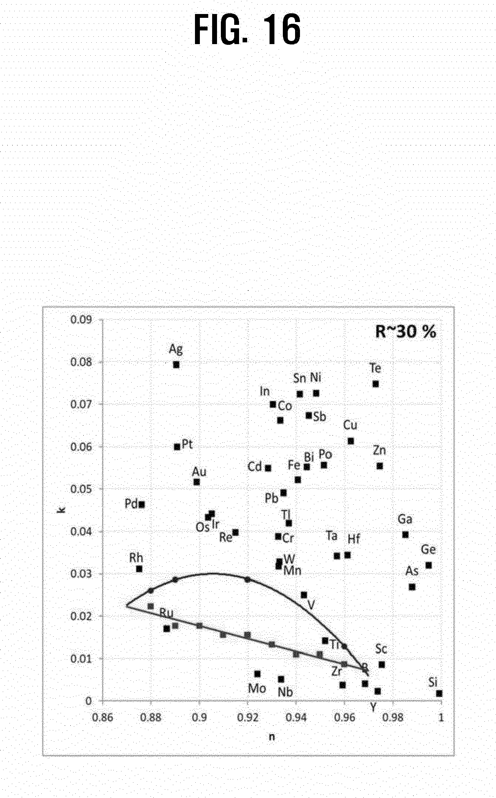

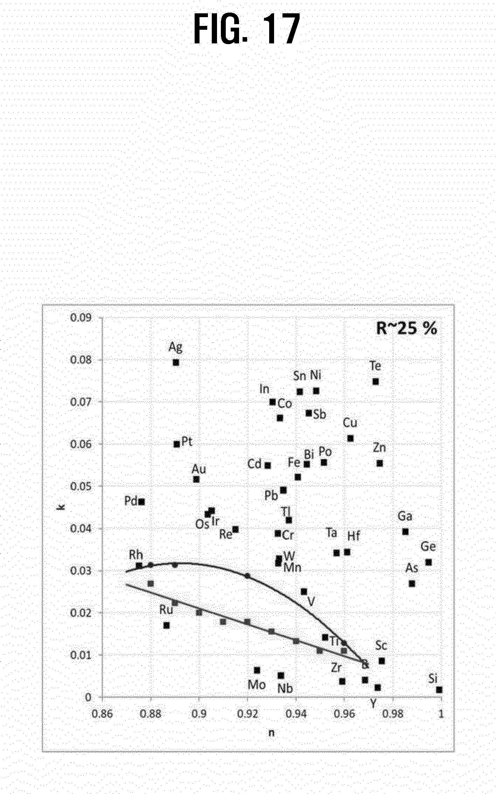

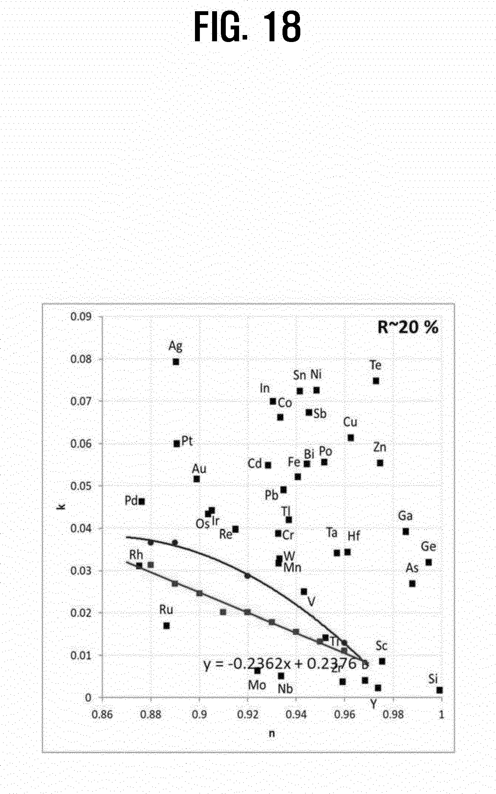

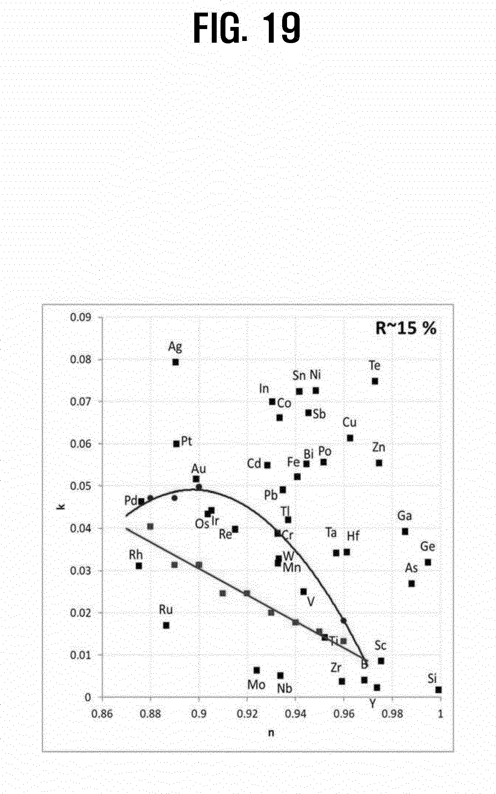

Figures 15 to 19 are graphs illustrating the required properties of the phase shift film to implement the reverse blankmask of this invention, showing the range related to the refractive index (n) and extinction coefficient (k) for EUV exposure light for each reflectivity range.

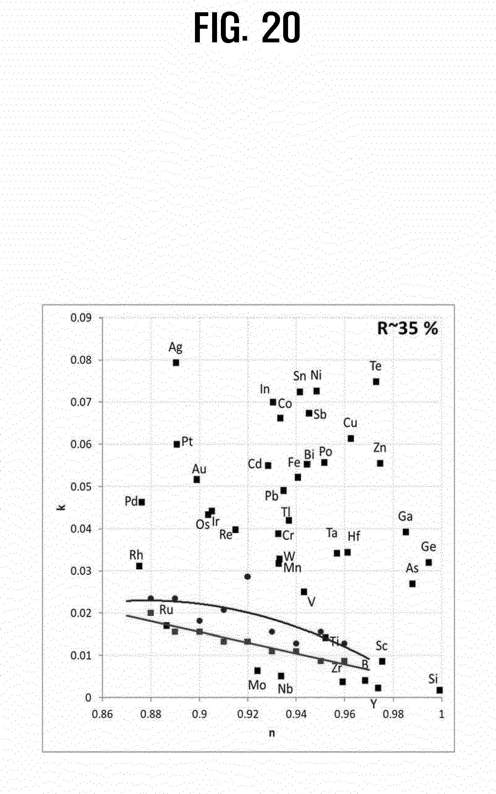

Figures 20 to 24 are graphs showing a reduced range compared to each range depicted in Figures 15 to 19.

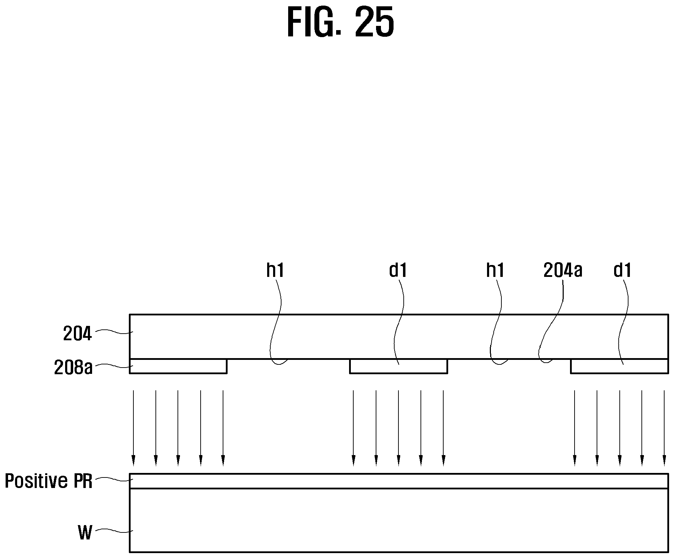

Figures 25 to 28 sequentially illustrate the process of patterning a wafer applied with positive photoresist using the reverse photomask according to this invention.

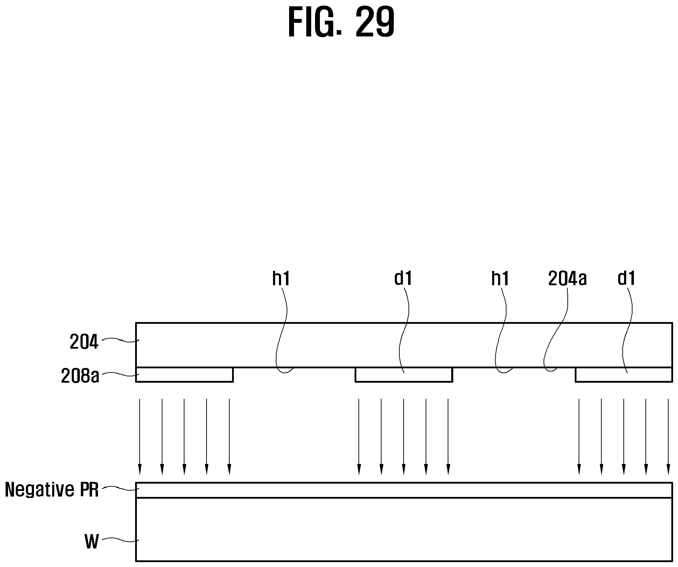

Figures 29 to 32 sequentially illustrate the process of patterning a wafer applied with negative photoresist using a different reverse photomask according to this invention.

## DETAILED DESCRIPTION OF EXEMPLARY EMBODIMENTS

The following describes this invention in more detail with reference to the accompanying drawings.

Figures 11 and 12 illustrate a reverse blankmask and a reverse photomask according to this invention, respectively. The basic structure of the blankmask and photomask according to this invention is the same as the conventional blankmask and photomask described with reference to Figures 1 and 2. Therefore, in the following description of this invention, the basic structure of the blankmask and photomask will be described briefly, and the description of the conventional blankmask and photomask referred to in Figures 1 and 2 will be adopted for this invention.

As shown in Figure 11, the blankmask of this invention includes a substrate 202, a reflective film 204 formed on the substrate 202, a capping film 205 formed on the reflective film 204, a phase shift film 208 formed on the capping film 205, and a resist film 220 formed on the phase shift film 208. The photomask is manufactured using such a blankmask. The photomask in Figure 12 has a phase shift pattern 208a and a reflective film pattern 204a patterned using the resist film 120.

If other thin films, such as an etch stop film or a hardmask film, remain above and/or below the specific thin film performing the main phase shift function and have the same pattern as the phase shift pattern 208a, then the entire stacked structure including this specific thin film and the other thin films performs the phase shift function. Therefore, in such cases within the photomask where multiple thin films exist as patterns performing the phase shift function, the term 'phase shift film' 208 in the description of this invention refers to the entire stacked structure of these films.

In the reverse photomask as well, the absolute reflectivity of the phase shift pattern 208a is lower than that of the reflective film pattern 204a. Therefore, similarly to conventional photomasks, incident light striking the photomask is reflected by the reflective film pattern 204a and shaded by the phase shift pattern 208a. More precisely, due to the lower reflectivity in the phase shift pattern 208a compared to the reflective film pattern 204a, a contrast difference occurs, and it is this contrast difference that patterns and reflects the incident light. However, as detailed later in detail, in the reverse photomask of this invention, the reflected light and its diffracted light undergo interference on their path to being projected onto the wafer (W), resulting in the blocking of reflected exposure light in the area of the wafer corresponding to the reflective film pattern 204a of the photomask and the projection of reflected exposure light in the area of the wafer corresponding to the phase shift pattern 208a of the photomask. As a result, from the wafer's perspective, it is as if the hole pattern of the photomask functions like a shading pattern and the dot pattern functions like a reflective pattern.

For the convenience in explaining this aspect, the following description of this invention's reverse photomask will use 'phase shift pattern' and 'reflective pattern' as terms with identical meanings, and 'reflective film pattern' and 'shading pattern' as terms with identical meanings. Furthermore, such terms with identical meanings will be referred to using the same reference numerals.

In the following, the principle by which the phase shift pattern 208a functions as a reflective pattern and the reflective film pattern 204a functions as a shading pattern in the reverse photomask of this invention is described.

The basic principle of the reverse photomask is to use the diffracted light from the reflected light of one pattern (for example, a dot pattern) on the photomask to cause destructive interference with the reflected light of other opposite pattern (for example, a hole pattern).

Figure 13 explains the diffraction of reflected light.

When exposure light is reflected from a reflective surface, diffraction occurs in the reflected light. The diffracted light along the main path of reflection is called the 0th-order diffracted light (D0), and the diffracted light forming a diffraction angle ($\theta$) relative to the main path is called the 1st-order diffracted light (D1). Since diffraction occurs symmetrically in all directions in space, there exists a -1st-order diffracted light (-D1) symmetrical to the 1st-order diffracted light (D1). Although not shown in Figure 13, symmetrical diffracted lights exist in the direction entering and exiting the plane of Figure 13. That is, diffraction occurs in all directions on the surface of the reflective film. Moreover, though not shown in Figure 13, there exists second-order diffracted light diffracted at angles (e.g., $\theta 2$) greater than the diffraction angle ($\theta$), and similarly, nth-order diffracted light exists. In the explanation of the principle of this invention that utilizes diffraction, n-th order diffracted light and -1st-order diffracted light (-D1) are omitted from illustration and description.

The reverse photomask induces destructive interference between the 0th-order diffracted light and 1st-order diffracted light, by ensuring that the 1st-order diffracted light reflected from the photomask is expressed at a position spaced an integer multiple of the half-pitch of the pattern away from the expression location of the 0th-order diffracted light on the wafer (W). Here, the 'expression location' refers to the position where the intensity peak of the diffracted light occurs. Utilizing this, from the wafer's (W) perspective, the reflectivity of the reflective film pattern 204a seems lower than that of the phase shift pattern 208a, experiencing a reversal effect. In other words, exposure light is blocked in the area of the wafer (W) corresponding to the hole (h1) of the photomask, and exposure light is projected in the area of the wafer (W) corresponding to the dot (d1) of the photomask.

Figure 14 specifically explains this effect, showing the intensity variation of light diffracted when exposure light is reflected by the photomask of Figure 12. In Figure 14, three reflective patterns 208a-1, 208a-2, and 208a-3 out of the reflective patterns 208a in Figure 12 are enlarged. Between the three reflective patterns 208a-1, 208a-2, and 208a-3, there are two shading patterns 204a-1, and 204a-2. For the convenience in explanation, the capping film 205 is omitted in Figure 14. The intensity variation graphs (Rh, Rd) of the reflected and diffracted light are divided according to the areas where each pattern 208a-1, 208a-2, 208a-3, 204a-1, and 204a-2 is formed on the photomask.

Rh is a graph showing the reflected(0th-order diffracted) light and 1st-order diffracted light in the shading patterns 204a-1, and 204a-2, with Rh-1 showing the 0th-order and 1st-order diffracted light in the left shading pattern 204a-1, and Rh-2 showing the same in the right shading pattern 204a-2. Rd is a graph showing the reflected(0th-order diffracted) light and 1st-order diffracted light in the reflective patterns 208a-1, 208a-2, and 208a-3, with Rd-1, Rd-2, and Rd-3 showing the diffracted light in the left, middle, and right reflective patterns 208a-1, 208a-2, and 208a-3, respectively.

The areas (W1, W2, W3) divided for each graph in Figure 14 correspond not to the areas on the photomask but to the areas on the wafer (W) corresponding to each area on the photomask. For example, the W2 area corresponds to the area on the wafer (W) corresponding to the middle reflective pattern 208a-2 on the photomask in Figure 14, and the W1 and W3 areas correspond to the areas on the wafer (W) corresponding to the left and right shading patterns 204a-1 and 204a-2 on the photomask, respectively.

In each graph of Rh and Rd, the 0th-order diffracted light exists in the area of the wafer (W) corresponding to the area where the pattern is formed, and the 1st-order diffracted light exists in the areas of the wafer (W) corresponding to the left and right of the patterned area. For instance, for the reflected light from the left shading pattern 204a-1, the 0th-order diffracted light exists in area W1, and the 1st-order diffracted light exists in the left area of W1 and the right area (W2) of W1 respectively. Similarly, for the reflected light from the middle reflective pattern 208a-2, the 0th-order diffracted light exists in area W2, and the 1st-order diffracted light exists in the left area (W1) of W2 and the right area (W3) of W2 respectively.

For the patterns 208a-1, 208a-2, 208a-3, 204a-1, 204a-2, diffracted light of the 2nd order and nth-order diffracted lights are omitted from illustration. The nth-order diffracted lights have very small intensity and thus have a negligible effect on the destructive interference and the constructive interference described below. Furthermore, the graphs (Rh, Rd) in Figure 14 are illustrated with an approximate phase difference of $\pi$ between areas (W1, W2, W3) on the wafer (W) for the clarity of understanding, but this does not represent an absolute phase difference. The actual phase difference, as will be detailed later, may differ from Figure 14 based on the premise that the intensity of the light projected on one area (e.g., W2) becomes greater than that projected on its left and right areas (e.g., W1, W3) due to destructive and constructive interference.

In Rh graph which is first graph in Figure 14, Rh-1 shows the intensity variation in each area of the wafer (W) when the reflected light from the left shading pattern 204a-1 is projected onto the wafer (W). The 0th-order diffracted light from the left shading pattern (204a-1) has the strongest intensity in the central part of area (W1) and decreases towards the edges. Intensity variations due to the 1st-order diffracted light occur in the areas (left area of W1, and W2) adjacent to area (W1). The 1st-order diffracted light, which is lower in intensity compared to the 0th-order diffracted light, has a distribution that is strongest in the central part of each area and weakens towards the edges. The phase of the 1st-order diffracted light is opposite to that of the 0th-order diffracted light.

Rh-2 shows the intensity variation in each area of the wafer (W) when the reflected light from the right shading pattern 204a-2 is projected onto the wafer (W). The 0th-order diffracted light from the right shading pattern 204a-2 has the strongest intensity in the central part of area (W3) and decreases towards the edges. Intensity variations due to the 1st-order diffracted light occur in the areas (W2, and right area of W3) adjacent to area (W3). The 1st-order diffracted light, which is lower in intensity compared to the 0th-order diffracted light, has a distribution that is strongest in the central part of each area and weakens towards the edges. The phase of the 1st-order diffracted light is opposite to that of the 0th-order diffracted light.

The 1st-order diffracted light heading right from Rh-1 and the 1st-order diffracted light heading left from Rh-2 overlap in area W2, resulting in constructive interference. Therefore, the combined intensity of the 1st-order diffracted lights in area W2 is approximately twice that of each 1st-order diffracted light.

In Rd graph which is second graph in Figure 14, Rd-2 shows the intensity variation in each area (W1, W2, W3) of the wafer (W) when the reflected light from the middle reflective pattern 208a-2 is projected onto the wafer (W). The 0th-order diffracted light from the middle reflective pattern 208a-2 has the strongest intensity in the central part of area (W2) and decreases towards the edges. Intensity variations due to the 1st-order diffracted light occur in the areas (W1, W3) adjacent to area (W2). The 1st-order diffracted light, which is lower in intensity compared to the 0th-order diffracted light, has a distribution that is strongest in the central part of each area and weakens towards the edges. The phase of the 1st-order diffracted light is opposite to that of the 0th-order diffracted light.

Rd-1 and Rd-3 represent the intensity variations in each area of the wafer (W) when the reflected light from the left reflective pattern 208a-1 and the right reflective pattern 208a-3 respectively are projected onto the wafer (W). Rd-1 and Rd-3 have the same shape as Rd-2, with the 0th-order diffracted light existing in the left area of W1 and the right area of W3 respectively, and the 1st-order diffracted light existing in areas W1 and W3 respectively. As a result, in area W1, the 1st-order diffracted light from Rd-1 and the 1st-order diffracted light from Rd-2 overlap, causing constructive interference, and in area W3, the 1st-order diffracted light from Rd-3 and the 1st-order diffracted light from Rd-2 overlap, causing constructive interference. Therefore, the combined intensity of the 1st-order diffracted lights in areas W1 and W3 is approximately twice the size of each 1st-order diffracted light.

Rh + Rd graph, which is third graph in Figure 14, shows the distribution of light (combination of Rh and Rd) projected onto each area (W1, W2, W3) of the wafer (W). Destructive interference occurs in each area (W1, W2, W3) due to the overlap of Rh and Rd, resulting in the intensity of light projected onto the area corresponding to the middle reflective pattern 208a-2 (W2) being higher than the intensity of light projected onto the areas (W1, W3) corresponding to the shading patterns on both sides 204a-1, and 204a-2. The phase in area W2 is opposite to that in areas W1 and W3.

Since the reflective film 204 has a higher absolute reflectivity compared to the phase shift film 208, the intensity of light directly reflected by the phase shift film 208 is lower than that reflected by the reflective film 204. Therefore, the intensity of light directly reflected from each reflective pattern 208a-1, 208a-2, and 208a-3 that makes up Rd is fundamentally lower than the intensity of light directly reflected from each shading pattern 204a-1, and 204a-2 that makes up Rh. However, the intensity of the projected light combining the Oth-order and 1st-order diffracted light, due to the aforementioned destructive and constructive interference, ends up being greater in W2 than in W1 and W3. Therefore, in the areas (W1, W3) on wafer (W) corresponding to the hole pattern (reflective film pattern 204a) of the photomask, exposure light is blocked, and in the area (W2) corresponding to the dot pattern (phase shift pattern 208a) of the photomask, exposure light is reflected. More precisely, since the intensity of the projected light is greater in W2 than in W1 and W3, patterned light with contrast difference projects onto the wafer (W), implementing this invention's reverse photomask.

In the illustration and explanation of Figure 14, the reflective pattern 208a and shading pattern 204a are exemplified as line patterns. Therefore, in Figure 14, the 1st-order diffracted light from each pattern 204a, and 208a is shown to occur in the left and right areas of the Oth-order diffracted light's generation area. However, if the shading pattern 204a is not a line pattern but a hole pattern (i.e., in a plane view of Figure 14's photomask looking from top to bottom, the shading pattern 204a forms a hole shape), the shading pattern 204a is surrounded by reflective patterns 208a on all sides.

In this situation, Rd would include constructive interference caused by four, not two, 1st-order diffracted lights. In this case, the magnitude of Rd in areas W1 and W3 is approximately doubled due to the quadrupled constructive interference compared to Figure 14. Therefore, the effect of destructive interference against Rh in areas W1 and W3 increases, and the magnitude of Rh + Rd in areas W1 and W3 is reduced compared to what is depicted in Figure 14. This results in an increased contrast difference in areas W1 and W3 with respect to area W2.

In the following, the specific configuration of a reverse photomask according to the principle described above is detailed.

To implement the reverse photomask of this invention, the distance between the expression location of the diffracted light and the expression location of the reflected light must match an integer multiple of the half-pitch of the pattern to be formed on the wafer (W), as previously described. This factor must be adjusted through the settings of the exposure device performing the exposure process, for example, by adjusting the focusing position through the distance between the photomask and the wafer (W) to meet these requirements. Therefore, this factor is more of a consideration during the actual use of the photomask rather than a specification of the photomask itself. However, using a general photomask, adjusting the distance between the photomask and the wafer (W) does not achieve a reverse effect, and to be used as a reverse photomask, the blankmask must be manufactured with specifications described below.

For the reverse photomask of this invention to be implemented effectively, destructive and constructive interference must occur, which requires the phase shift film 208 to have a high reflectivity so that the intensity of diffracted light increases. According to the research conducted by the inventors of this invention, the phase shift film 208 must have a reflectivity greater than 15% to implement the reverse photomask. However, the inventors have found that too high a reflectivity can actually hinder the implementation of the reverse function. A preferable reflectivity for the phase shift film 208 is less than 35%. Here, reflectivity refers to the reflectivity for EUV exposure light with a wavelength of 13.5nm, and also to the relative reflectivity, which is the ratio of the absolute reflectivity of the phase shift film 208 compared to the reflective film 204.

Conventional phase shift films are designed to effectively generate destructive interference between the reflected lights from the top and bottom of the phase shift film, thereby setting the phase shift amount close to 180°. Conventionally, the target phase shift amount for phase shift films is set within the range of 160-210°. However, the inventors of this invention have discovered that reverse photomasks can be effectively implemented in a different range of phase shifts amount than what is typically sought in conventional photomasks. According to their research, phase shift amount within the range of 150-220° does not effectively implement the reverse function, while phase shift amount in the range of 110-150° or 220-250° do effectively implement the reverse function.

To have the phase shift film 208 have the aforementioned reflectivity and phase shift amount, the material composing the phase shift film 208 must have an appropriate extinction coefficient (k) and refractive index (n).

The appropriate reflectivity mentioned can be set through adjusting the extinction coefficient (k) and thickness (t) of the phase shift film 208. However, to meet the described phase shift amount range and achieve maximum performance in terms of NILS and DtS, an appropriate range of refractive index (n) is required. In other words, for the effective implementation of the reverse function, the phase shift film 208 must have appropriate optical constants ($N = n-ik$). However, the refractive index (n) and extinction coefficient (k), which represent the optical properties of a thin film, are not independent of each other from the perspective of expressing the maximum performance of the phase shift film 208. The requirements for the phase shift film considering these aspects must be expressed as a function defining the relationship between k and n.

Furthermore, the inventors of this invention have discovered that for the implementation of the reverse function of the phase shift film, the interrelationship between k and n defining the function must change according to the target reflectivity range. That is, one phase shift film 208 with a specific range of reflectivity and other phase shift film 208 with a different range of reflectivity require different ranges of k and n values. Meanwhile, reflectivity must be implemented to match the requirements of individual exposure processes. For example, one exposure process may require a reflectivity of 20%, while another may require 25%. The phase shift film 208 must be manufactured to have the reflectivity that meets these requirements. When the required reflectivity differs, the range of n and k for the phase shift film 208 for implementing the reverse function also differs.

Considering these various aspects, the range of values for n and k of the phase shift film 208 for implementing the reverse photomask of this invention is preferably determined as different functions according to the reflectivity range.

Figures 15 to 19 are graphs showing the required properties for the phase shift film to implement the reverse photomask of this invention, presented as ranges related to the refractive index (n) and extinction coefficient (k) for EUV exposure light for each reflectivity range. Figures 15 to 19 show the ranges of n and k values where the reverse function is implemented for reflectivity ranges of 32.5 < R < 35%, 27.5 < R < 32.5%, 22.5 < R < 27.5%, 17.5 < R < 22.5%, and 15 < R < 17.5% respectively. The horizontal axis in these graphs represents the refractive index (n) for EUV exposure light with a wavelength of 13.5nm, and the vertical axis represents the extinction coefficient (k) for the same. The range enclosed by lines and partial arcs in each graph represents the range where the implementation of this invention's reverse photomask is possible. Materials outside this range have difficulty implementing the reverse function or, even if implemented, may struggle to meet other required performance specifications, such as DtS (Dose to Space) or NILS (Normalized Image Log Slope).

The ranges in Figures 15 to 19 can be expressed by the following formulas:

For 32.5% < R < 35%: $-0.1275n + 0.1305 < k < -6.6692n^2 + 12.1540n - 5.5071$
For 27.5% < R < 32.5%: $-0.1500n + 0.1530 < k < -6.0311n^2 + 10.9240n - 4.9149$
For 22.5% < R < 27.5%: $-0.1875n + 0.1900 < k < -4.2609n^2 + 7.6028n - 3.3581$
For 17.5% < R < 22.5%: $-0.2362n + 0.2376 < k < -2.5346n^2 + 4.3613n - 1.8379$
For 15% < R < 17.5%: $-0.3112n + 0.3108 < k < -7.9010n^2 + 14.1850n - 6.3175$

Where R is the relative reflectivity of the phase shift film for EUV exposure light at a wavelength of 13.5nm, k is the extinction coefficient, and n is the refractive index for the same wavelength.

Materials within the stated ranges could fulfill the formulas by themselves, or a combination of several materials outside these ranges could be mixed so that the compound satisfies the formulas. Additionally, a multi-layer structure of the phase shift film 208 incorporating one or several materials or compounds outside these ranges could be formed so that the effective optical constants (eff. N) of the entire phase shift film 208 satisfy the formulas.

For a two-layer case, the effective optical constant (eff. N) is defined by the following formula:

$$\text{eff. } N = (n1 \times t1 + n2 \times t2)/(t1 + t2) - i(k1 \times t1 + k2 \times t2)/(t1 + t2)$$

(where n1, k1, t1 are the refractive index, extinction coefficient, and thickness of the first layer, respectively, and n2, k2, t2 are those of the second layer)

The phase shift film 208 can also include light elements such as N, O, C, B, H, in addition to metals, and the refractive index (n) and extinction coefficient (k) of the phase shift film 208 are determined by the presence and amount of these light elements. Therefore, by adjusting the content of both metals and light elements in the phase shift film 208, it is possible to achieve the phase shift film 208 with n and k values within the specified range.

Meanwhile, to secure a high reflectivity of the phase shift film 208, it is preferable for the phase shift film 208 to be thin. Thus, in the reverse photomask of this invention pursuing high reflectivity, the thickness of the phase shift film 208 is reduced compared to conventional phase shift films, thereby achieving the effect of reducing the 3D effect. Using materials with a high refractive index (n) and low extinction coefficient (k), it is possible to implement effective reverse functionality with a thickness of, for example, 60nm that meets the specified requirements. However, in cases satisfying the described formulas for R, n, k values presented in this invention, the phase shift film 208 more easily implements the reverse function with a thickness of less than 45nm, also gaining an additional effect of reducing the 3D effect. Furthermore, it is preferable for the thickness of the phase shift film 208 to be less than 35nm, and more preferably less than 30nm. It goes without saying that the phase shift film 208 must be thicker than the minimum thickness required to function as a thin film for phase shift.

Figures 20 to 24 are graphs showing ranges reduced from those depicted in Figures 15 to 19. It was confirmed that the performance of the reverse photomask of this invention is superior in these somewhat reduced ranges, as shown in Figures 20 to 24. The formulas corresponding to each reflectivity shown in each figure are as follows:

For 32.5% < R < 35%: $-0.1275n + 0.1305 < k < -1.6193n^2 + 2.8439n - 1.2255$
For 27.5% < R < 32.5%: $-0.1500n + 0.1530 < k < -1.3636n^2 + 2.3341n - 0.9713$
For 22.5% < R < 27.5%: $-0.1875n + 0.1900 < k < -1.7045n^2 + 2.9001n - 1.2006$

For 17.5% < R < 22.5%: -0.2362n + 0.2376 < k < -0.9554n^2 + 1.4681n - 0.5146
For 15% < R < 17.5%: -0.3112n + 0.3108 < k < -0.7670n^2 + 0.9870n - 0.2242

In the formulas corresponding to each range in Figures 20 to 24, the formula defining the lower limit of k is the same as previously described for Figures 15 to 19, but the permitted area by the formula defining the upper limit of k is reduced compared to the formulas for Figures 15 to 19. Meeting these formulas results in superior performance as a reverse photomask and reduces the likelihood of defects due to product tolerance in the manufacturing process.

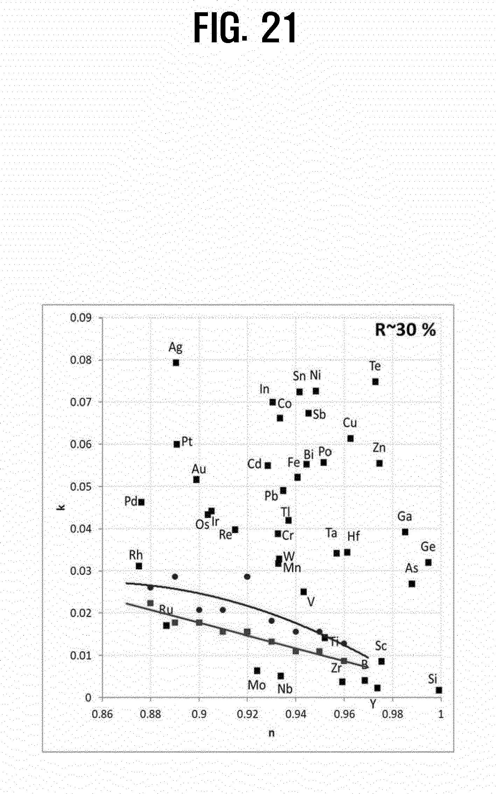

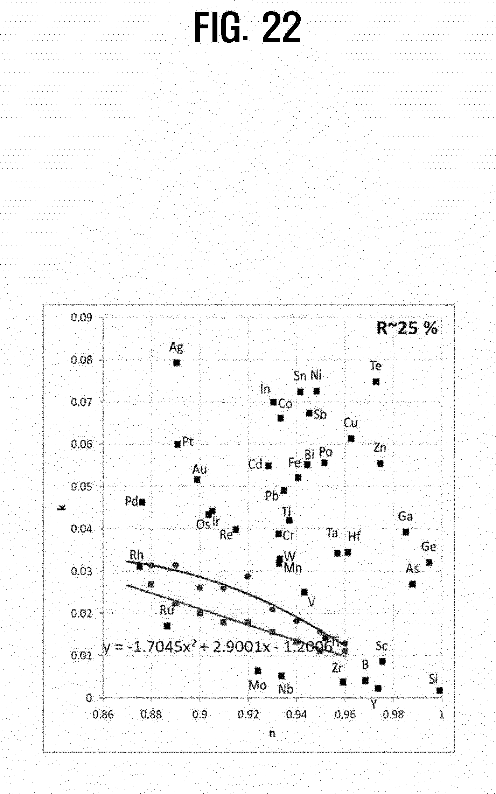

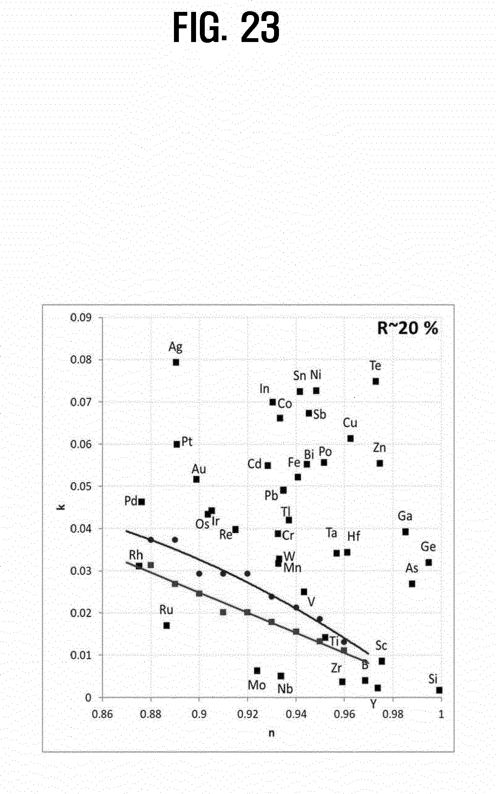

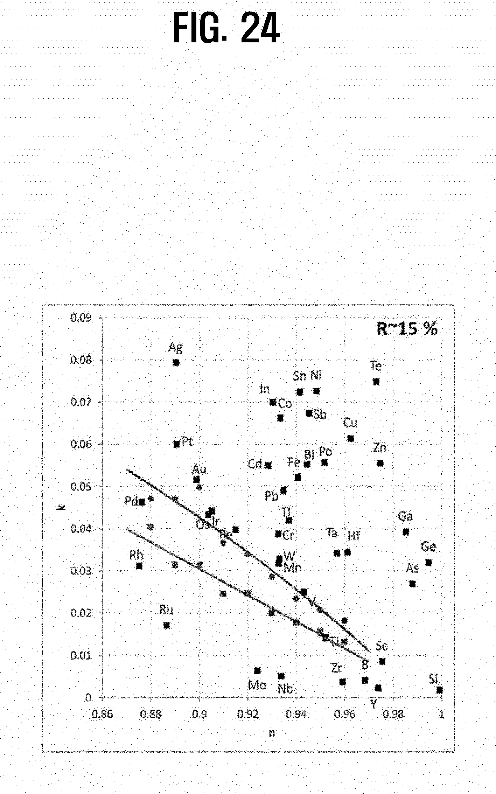

Meanwhile, the inventors of this invention have discovered that there exists a special range where the production of this invention's reverse photomask is possible, even outside the ranges expressed by the aforementioned formulas. In Figures 20 to 22, and 24, these special ranges are depicted as points outside the areas demarcated in each figure. For instance, in Figure 20, a point where n is approximately 0.92 and k is slightly less than approximately 0.03 is indicated. These special ranges exist in one area in Figure 20, two areas in Figure 21, one area in Figure 22, and one area in Figure 24, with none in Figure 23. Expressed in relation to the reflectivity range of each figure, these special ranges are as follows:

For 32.5% < R < 35%, n=0.92±0.01, -0.1275n + 0.1305 < k < 0.03
For 27.5% < R < 32.5%, n=0.89±0.01 or n=0.92±0.01, -0.1500n + 0.1530 < k < 0.03
For 22.5% < R < 27.5%, n=0.92±0.01, -0.1875n + 0.1900 < k < 0.03
For 15% < R < 17.5%, n=0.90±0.01, -0.3112n + 0.3108 < k < 0.05

As previously discussed, the formulas for Figures 15 to 19 and Figures 20 to 24 require satisfying at least one of the conditions concerning the phase shift amount and thickness of the phase shift film 208. That is, a phase shift amount of 110-150° or 220-250° is required for the phase shift film 208, and its thickness must be below 45nm, preferably less than 35nm, and even more preferably less than 30nm. However, even if only one of these two conditions is met, the production of this invention's reverse photomask is possible, and meeting both conditions ensures even greater performance of the reverse photomask.

The following describes the exposure process using the reverse photomask according to this invention.

Figures 25 to 28 sequentially illustrate the process of patterning a wafer using the reverse photomask of this invention, showing the process for a wafer (W) employing positive photoresist PR.

As previously mentioned, in this invention's reverse photomask, the phase shift pattern 208a functions as a reflective pattern for incident light, and the reflective pattern 204a functions as a shading pattern for incident light. With this consideration, Figures 25 to 28 illustrate the patterning process of the reverse photomask to be conceptually clear by showing the incident light being reflected by the phase shift pattern 208a and shaded by the reflective pattern 204a.

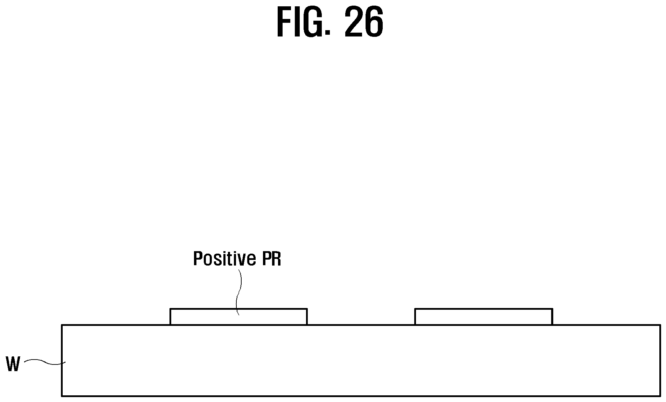

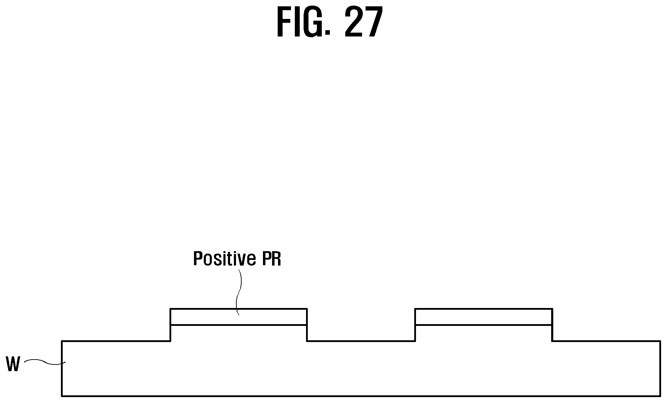

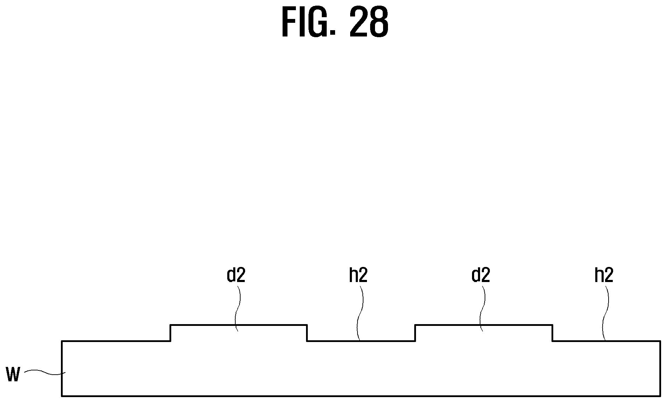

As shown in Figure 25, in the case where positive photoresist is used, areas of positive photoresist exposed to reflected light are removed, leaving the rest, as shown in Figure 26. Using the patterned positive photoresist as an etch mask, the wafer (W) is etched as shown in Figure 27, and after completing the etching, the positive photoresist is removed, resulting in a patterned wafer (W) as shown in Figure 28.

As can be seen from Figures 25 and 28, when patterning a wafer (W) employing positive photoresist using the reverse photomask, the holes (h1) of the photomask form dots (d2) on the wafer (W), and the dots (d1) of the photomask form holes (h2) on the wafer (W).

Figures 29 to 32 sequentially illustrate the process of patterning a wafer using the reverse photomask of this invention, showing the process for a wafer (W) employing negative photoresist PR.

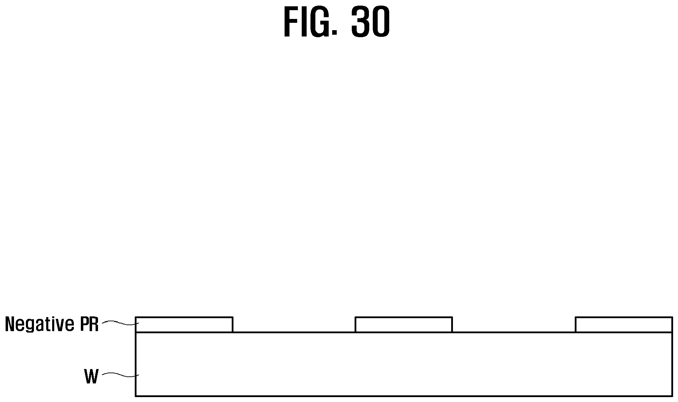

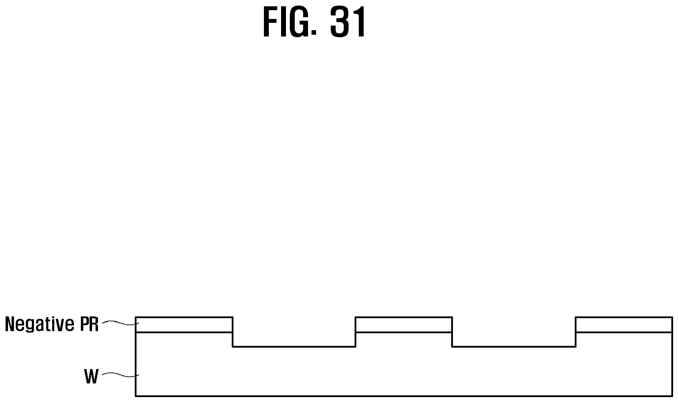

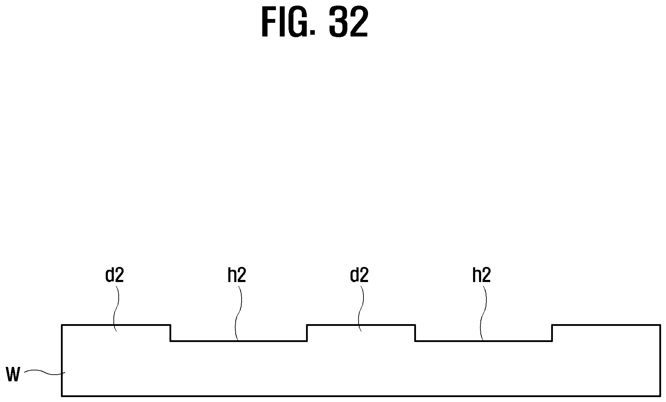

As shown in Figure 29, in the case where negative photoresist is used, areas of negative photoresist that are not exposed to reflected light are removed, leaving the rest, as shown in Figure 30. Using the patterned negative photoresist as an etch mask, the wafer (W) is etched as shown in Figure 31, and after completing the etching, the negative photoresist is removed, resulting in a patterned wafer (W) as shown in Figure 32.

As can be seen from Figures 29 and 32, when patterning a wafer (W) employing negative photoresist using the reverse photomask, the holes (h1) of the photomask form holes (h2) on the wafer (W), and the dots (d1) of the photomask form dots (d2) on the wafer (W).

Thus, when performing the exposure process on a wafer using the reverse photomask according to the invention, in the case of patterning a wafer (W) employing a positive photoresist, the hole (h1) of the photomask forms a dot (d2) on the wafer (W), and the dot (d1) of the photomask forms a hole (h2) on the wafer (W). Conversely, when patterning a wafer (W) employing a negative photoresist, the hole (h1) of the photomask forms a hole (h2) on the wafer (W), and the dot (d1) of the photomask forms a dot (d2) on the wafer (W).

In summary, when exposing a wafer (W) employing a negative photoresist using a reverse photomask, the hole (h1) and dot (d1) of the photomask correspond to the hole (h2) and dot (d2) on the wafer (W), respectively, making the pattern of the photomask and the pattern of the wafer (W) the same. Therefore, using a reverse photomask allows for the application of negative photoresist even in the last exposure process of the entire exposure operation on the wafer (W), facilitating the formation of holes (h2).

Although details of the disclosure have been described above through a few embodiments of the disclosure with reference to the accompanying drawings, the embodiments are merely for the illustrative and descriptive purposes only but not construed as limiting the scope of the disclosure defined in the appended claims. It will be understood by a person having ordinary skill in the art that various changes and other equivalent embodiments may be made from these embodiments. Thus, the scope of the invention should be defined by the technical subject matters of the appended claims.

**Claims**

1. A reverse blankmask for extreme ultraviolet lithography, comprising:

   a substrate,
   a reflective film formed on the substrate, and
   a phase shift film formed on the reflective film,
   wherein a relative reflectivity of the phase shift film is greater than 15% for EUV exposure light at a wavelength of 13.5nm, and
   a phase shift amount of reflected light from the phase shift film during EUV exposure light incidence is within a range of 110-150° or 220-250°.

2. The reverse blankmask for extreme ultraviolet lithography according to claim 1, wherein the phase shift film has a relative reflectivity of less than 35%.

3. The reverse blankmask for extreme ultraviolet lithography according to claim 1 or 2, wherein the phase shift film has a thickness of less than 45nm.

4. The reverse blankmask for extreme ultraviolet lithography according to claim 1 or 2, wherein the phase shift film has a thickness of less than 35nm.

5. The reverse blankmask for extreme ultraviolet lithography according to claim 1 or 2, wherein the phase shift film has a thickness of less than 30nm.

6. A reverse blankmask for extreme ultraviolet lithography, comprising:

   a substrate,
   a reflective film formed on the substrate, and
   a phase shift film formed on the reflective film,
   wherein a relative reflectivity of the phase shift film is greater than 15% for EUV exposure light at a wavelength of 13.5nm, and
   a thickness of the phase shift film is less than 45nm.

7. The reverse blankmask for extreme ultraviolet lithography according to claim 6, wherein the phase shift film has a thickness of less than 35nm.

8. The reverse blankmask for extreme ultraviolet lithography according to claim 6, wherein the phase shift film has a thickness of less than 30nm.

9. The reverse blankmask for extreme ultraviolet lithography according to any one of claims 6 to 8, wherein the phase shift film has a relative reflectivity of less than 35%.

10. The reverse blankmask for extreme ultraviolet lithography according to any one of claims 1 to 9, wherein the phase shift film satisfies any one of the following formulas 1) to 5):

    1) $32.5\% < R < 35\%$, $-0.1275n + 0.1305 < k < -6.6692n^2 + 12.1540n - 5.5071$
    2) $27.5\% < R < 32.5\%$, $-0.1500n + 0.1530 < k < -6.0311n^2 + 10.9240n - 4.9149$
    3) $22.5\% < R < 27.5\%$, $-0.1875n + 0.1900 < k < -4.2609n^2 + 7.6028n - 3.3581$
    4) $17.5\% < R < 22.5\%$, $-0.2362n + 0.2376 < k < -2.5346n^2 + 4.3613n - 1.8379$
    5) $15\% < R < 17.5\%$, $-0.3112n + 0.3108 < k < -7.9010n^2 + 14.1850n - 6.3175$

(For EUV exposure light, R represents the relative reflectivity, k represents the extinction coefficient, and n represents the refractive index.)

11. The reverse blankmask for extreme ultraviolet lithography according to any one of claims 1 to 9, wherein the phase shift film satisfies any one of the following formulas 6) to 10):

6) 32.5% < R < 35%, -0.1275n + 0.1305 < k < -1.6193n^2 + 2.8439n - 1.2255
7) 27.5% < R < 32.5%, -0.1500n + 0.1530 < k < -1.3636n^2 + 2.3341n - 0.9713
8) 22.5% < R < 27.5%, -0.1875n + 0.1900 < k < -1.7045n^2 + 2.9001n - 1.2006
9) 17.5% < R < 22.5%, -0.2362n + 0.2376 < k < -0.9554n^2 + 1.4681n - 0.5146
10) 15% < R < 17.5%, -0.3112n + 0.3108 < k < -0.7670n^2 + 0.9870n - 0.2242

(For EUV exposure light, R represents the relative reflectivity, k represents the extinction coefficient, and n represents the refractive index.)

12. The reverse blankmask for extreme ultraviolet lithography according to any one of claims 1 to 9, wherein the phase shift film satisfies any one of the following formulas 11) to 14):

11) 32.5% < R < 35%, n=0.92±0.01, -0.1275n + 0.1305 < k < 0.03
12) 27.5% < R < 32.5%, n=0.89±0.01 or n=0.92±0.01, -0.1500n + 0.1530 < k < 0.03
13) 22.5% < R < 27.5%, n=0.92±0.01, -0.1875n + 0.1900 < k < 0.03
14) 15% < R < 17.5%: at n=0.90±0.01, -0.3112n + 0.3108 < k < 0.05

(For EUV exposure light, R represents the relative reflectivity, k represents the extinction coefficient, and n represents the refractive index.)

13. The reverse photomask for extreme ultraviolet lithography, manufactured using the blankmask according to any one of claims 1 to 12.

14. A method of exposing a wafer, comprising the steps of:

manufacturing the reverse photomask of claim 13; and
exposing the wafer using the reverse photomask.

15. The method of exposing a wafer according to claim 14, wherein the wafer employs negative photoresist during the exposing step.

# FIG. 1
# (PRIOR ART)

120
108
105
104
102

# FIG. 2
# (PRIOR ART)

# FIG. 3
# (PRIOR ART)

h1      d1      h1    104a    d1

104

108a

Positive PR

W

# FIG. 4
# (PRIOR ART)

Positive PR

W

# FIG. 5
# (PRIOR ART)

Positive PR

W

# FIG. 6
# (PRIOR ART)

# FIG. 7
# (PRIOR ART)

# FIG. 8
# (PRIOR ART)

Negative PR

W

# FIG. 9
# (PRIOR ART)

Negative PR

W

# FIG. 10
# (PRIOR ART)

# FIG. 11

220
208
205
204
202

# FIG. 12

# FIG. 13

# FIG. 14

# FIG. 15

# FIG. 16

# FIG. 17

# FIG. 18

# FIG. 19

# FIG. 20

# FIG. 21

# FIG. 22

# FIG. 23

# FIG. 24

# FIG. 25

# FIG. 26

Positive PR

W

# FIG. 27

Positive PR

W

# FIG. 28

d2    h2    d2    h2

W

# FIG. 29

# FIG. 30

Negative PR

W

# FIG. 31

Negative PR

W

# FIG. 32

Europäisches
Patentamt

European
Patent Office

Office européen
des brevets

# EUROPEAN SEARCH REPORT

**Application Number**

EP 24 17 6403

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>A | WO 2023/095769 A1 (TOPPAN PHOTOMASK CO LTD [JP]) 1 June 2023 (2023-06-01)<br>* abstract *<br>& EP 4 439 174 A1 (TOPPAN PHOTOMASK CO LTD [JP]) 2 October 2024 (2024-10-02)<br>* abstract *<br>* figures 1,10 *<br>* paragraphs [0001], [0034] - [0037], [0056] - [0068], [0105] - [0111], [0244] * | 1-4,6,7,<br>9-14<br>5,8,15 | INV.<br>G03F1/26 |
| A | US 2023/168575 A1 (IKEBE YOHEI [JP] ET AL) 1 June 2023 (2023-06-01)<br>* abstract *<br>* figure 1 *<br>* paragraphs [0002], [0264] - [0270] * | 1-15 | |

**TECHNICAL FIELDS SEARCHED (IPC)**

G03F

The present search report has been drawn up for all claims

| Place of search | Date of completion of the search | Examiner |
|---|---|---|
| Munich | 8 January 2025 | Andersen, Ole |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 17 6403

This annex lists the patent family members relating to the patent documents cited in the above-mentioned European search report.
The members are as contained in the European Patent Office EDP file on
The European Patent Office is in no way liable for these particulars which are merely given for the purpose of information.

08-01-2025

| Patent document cited in search report | Publication date | Patent family member(s) | Publication date |
|---|---|---|---|
| WO 2023095769 A1 | 01-06-2023 | CN 118302719 A | 05-07-2024 |
| | | EP 4439174 A1 | 02-10-2024 |
| | | JP WO2023095769 A1 | 01-06-2023 |
| | | KR 20240090667 A | 21-06-2024 |
| | | TW 202336519 A | 16-09-2023 |
| | | WO 2023095769 A1 | 01-06-2023 |
| US 2023168575 A1 | 01-06-2023 | JP 7361027 B2 | 13-10-2023 |
| | | JP 2023166007 A | 17-11-2023 |
| | | JP WO2019225736 A1 | 10-06-2021 |
| | | KR 20210014619 A | 09-02-2021 |
| | | SG 11202011370V A | 30-12-2020 |
| | | TW 202004327 A | 16-01-2020 |
| | | TW 202424636 A | 16-06-2024 |
| | | US 2021208498 A1 | 08-07-2021 |
| | | US 2023168575 A1 | 01-06-2023 |
| | | US 2024036457 A1 | 01-02-2024 |
| | | WO 2019225736 A1 | 28-11-2019 |

EPO FORM P0459

For more details about this annex : see Official Journal of the European Patent Office, No. 12/82